# EUROPÄISCHE PATENTSCHRIFT

(11) **EP 2 945 288 B1**
(45) Veröffentlichungstag und Bekanntmachung des Hinweises auf die Patenterteilung: **24.02.2021**
(21) Anmeldenummer: 15167507.1
(22) Anmeldetag: 13.05.2015
(51) Int. Cl.: H03K 17/16, H03K 17/687, H03K 17/567, H03K 17/61, H03K 17/691

(54) **SCHALTUNGSANORDNUNG UND VERFAHREN ZUM ANSTEUERN EINES HALBLEITERSCHALTELEMENTS**
CIRCUIT ASSEMBLY AND METHOD FOR CONTROLLING A SEMICONDUCTOR SWITCHING ELEMENT
CIRCUIT ET PROCÉDÉ DE COMMANDE D'UN ÉLÉMENT COMMUTATEUR DE SEMI-CONDUCTEUR

(30) Priorität: 15.05.2014 AT 503412014
(43) Veröffentlichungstag der Anmeldung: 18.11.2015
(73) Patentinhaber: Fronius International GmbH, 4643 Pettenbach (AT)
(72) Erfinder: Magerl, Christian, 3921 Langschlag (AT); Schranz, Benjamin, 4600 Schleißheim (AT); Herndler, Jan, 4644 Scharnstein (AT); Högl, Andreas, 4611 Buchkirchen (AT)
(74) Vertreter: Patentanwälte Pinter & Weiss OG

(56) Entgegenhaltungen:
- EP-A2- 0 053 709
- DE-A1-102012 218 284
- JP-A- 2003 069 406
- JP-A- 2003 125 574
- JP-B2- 3 066 754
- US-A1- 2013 076 406
- US-A1- 2014 111 261

## Beschreibung

Die gegenständliche Erfindung betrifft eine Schaltungsanordnung zum Ansteuern eines Halbleiterschaltelements, wobei ein Gate-Treiber eine steilflankige Steuerspannung für das Halbleiterschaltelement erzeugt und der Gate-Treiber mit dem Steueranschluss des Halbleiterschaltelements verbunden ist.

Zum Schalten von aktiven Halbleiterschaltelementen, insbesondere Transistoren, wie beispielsweise ein Bipolartransistor mit isolierter Gate-Elektrode (IGBT) oder ein Metall-Oxid-Halbleiter-Feldeffekttransistor (MOSFET), werden sogenannte Gate-Treiber verwendet, die an den Steueranschluss des Halbleiterschaltelements (Gate-Anschluss beim IGBT und beim MOSFET) angeschlossen werden und die eine Treiber-Steuerspannung erzeugen, um den Stromfluss über das Halbleiterschaltelement zu kontrollieren. Ein herkömmlicher Standard Gate-Treiber erzeugt als Treiber-Steuerspannung eine steilflankige Rechteckspannung. Dadurch wird das Halbleiterschaltelement ohne Rücksicht auf das jeweilige Schaltverhalten angesteuert. Dies kann zu unerwünschten Oszillationen, Probleme durch hochfrequente elektromagnetische Abstrahlung, bis hin zur Zerstörung des Halbleiterschaltelements führen. Dafür sind solche Standard Gate-Treiber als Hardware Bausteine kommerziell günstig erhältlich. Die JP 3 066754 B2 und DE 10 2012 218 284 A1 zeigen beispielsweise eine Schaltung zum Ansteuern eines Halbleiterschaltelements, wobei ein unerwünschtes Schalten des Halbleiterschalters verhindert werden soll.

Im Stand der Technik finden sich bereits einige Lösungsansätze, um die genannte Probleme solcher Standard Gate-Treiber zu beseitigen bzw. zu reduzieren.

In der WO 2012/007558 A1 wird ein Verfahren und eine Anordnung zur Ansteuerung von Power-MOS-Transistoren offenbart. Hierbei wird der Transistor zum Ausschalten mit einer linear fallenden und zum Einschalten mit einer linear ansteigenden Steuerspannung angesteuert - also jeweils mit einer Spannungsrampe anstatt der steilflankigen Treiber-Steuerspannung. Schaltungstechnisch wird das durch einen Impedanzwandler mit Verstärker, Stromquellen und einem Kondensator erreicht, also durch eine aufwendige elektrische Schaltung.

Ebenso wurde bereits vorgeschlagen, die Spannungsflanken der Steuerspannung des Halbleiterschalters durch eine geschlossene Regelschleife aktiv zu regeln, wie z.B. in Lobsiger Y. et al., "Closed Loop di/dt & dv/dt Control and Dead Time Minimization of IGBTs in Bridge Leg Configuration", Proceedings 14th IEEE Workshop an Control an Modeling for Power Electronics (COMPEL 2013), Salt Lake City, USA, June 23-26, 2013. Eine solche aktive Regelung ist aber für einen Gate-Treiber sowohl hardware- als auch softwaremäßig aufwendig.

Beiden oben genannten Konzepten ist zudem gemein, dass beide eine komplett neue Schaltung für einen Gate-Treiber vorschlagen, die als Hardware, eventuell mit geeigneter Steuersoftware, zu entwickeln und umzusetzen ist. Die vorhandenen kostengünstigen Standard Gate-Treiber Bausteine sind damit nicht mehr einsetzbar, sondern müssen durch neu entwickelte ersetzte werden.

Die JP 2003 125574 A offenbart eine einfache Schaltung zum Abflachen von steilflankigen Steuerspannungen mittels einer RC-Schaltung. Die EP 0 053 709 A2 zeigt eine Schaltung zum Unterdrücken positiver Flanken.

Es ist nun eine Aufgabe der gegenständlichen Erfindung, die oben genannten Probleme beim Schalten von Halbleiterschaltelementen mit herkömmlichen Gate-Treibern auf einfache und kostengünstige Weise zu reduzieren.

Diese Aufgabe wird erfindungsgemäß dadurch gelöst, dass der Steueranschluss des Halbleiterschaltelements über eine Rampenerzeugungseinheit mit dem Ausgangsanschluss des Halbleiterschaltelements verbunden ist und die Rampenerzeugungseinheit zur Erzeugung einer Transistor-Steuerspannung am Ausgang der Rampenerzeugungseinheit die steil steigenden und fallenden Flanken der Treiber-Steuerspannung rampenförmig abflacht, die Energieversorgung der Rampenerzeugungseinheit durch den Gate-Treiber erfolgt und in der Rampenerzeugungseinheit ausgangsseitig einen Transistor angeordnet ist, der von einer rampenförmig ansteigenden oder abfallenden Spannung gesteuert ist, wodurch über den Transistor ein rampenförmig fallender oder steigender Transistorstrom fließt. Damit kann für die Ansteuerung des Halbleiterschaltelements wie bisher ein Standard Gate-Treiber verwendet werden, wobei die Nachteile der steilflankigen Treiber-Steuerspannung durch die Abflachung der steilen Flanken in der Rampenerzeugungseinheit vermindert werden. Die Rampenerzeugungseinheit ist eine einfache elektrische Zusatzbeschaltung und bedarf keiner aufwendigen Überarbeitung des Gate-Treibers, sondern kann einfach zwischen Gate-Treiber und Halbleiterschaltelement hinzugefügt werden, was es ermöglicht elektrische Schaltungen unter Verwendung von elektrischen Standardbauteilen sehr einfach zu adaptieren.

Zur Potentialtrennung kann zwischen Gate-Treiber und Rampenerzeugungseinheit auch ein Signalübertrager geschaltet sein.

Erfindungsgemäß ist in der Rampenerzeugungseinheit ausgangsseitig ein Transistor angeordnet, der von einer rampenförmig ansteigenden Spannung oder einer rampenförmig abfallenden Spannung gesteuert wird, wodurch über den Transistor ein rampenförmig fallender oder steigender Transistorstrom fließt. Der rampenförmige Strom über den Transistor zweigt vom Ausgangsstrom der Rampenerzeugungseinheit damit ab, wodurch auch der Ausgangsstrom rampenförmig ansteigt bzw. abfällt. Das bewirkt dann eine Transistor-Steuerspannung am Ausgang der Rampenerzeugungseinheit mit rampenförmig steigenden und fallenden Flanken - die steilen Flanken der Treiber-Steuerspannung wurden damit abgeflacht.

Die rampenförmige Spannung zum Ansteuern des Transistors wird vorteilhafter Weise dadurch erzeugt, dass in der Rampenerzeugungseinheit ein erster Transistor und eine RC-Ladeschaltung mit einem Widerstand und einer Kapazität vorgesehen sind, wobei der Transistor-Ausgangsanschluss des ersten Transistors mit dem Ausgangsanschluss der Rampenerzeugungseinheit verbunden ist, die RC-Ladeschaltung über den Widerstand mit dem Eingangsanschluss der Rampenerzeugungseinheit verbunden ist und die Kapazität der RC-Ladeschaltung mit dem Transistor-Steueranschluss des ersten Transistors verbunden ist. Das lässt sich mit elektrischen Standardbauteilen auf einfachste Weise realisieren. Durch einfache Dimensionierung der RC-Ladeschaltung kann darüber hinaus auch die Wirkung der Abflachung der steilen Flanken der Treiber-Steuerspannung einfach kontrolliert werden.

In einer anderen Ausgestaltung der Erfindung, sind in der Rampenerzeugungseinheit ein erster Transistor, ein zweiter Transistor und eine RC-Ladeschaltung mit einem Widerstand und einer Kapazität vorgesehen, wobei der Transistor-Ausgangsanschluss des ersten Transistors und des zweiten Transistors miteinander und mit dem Ausgangsanschluss der Rampenerzeugungseinheit verbunden sind, der Transistor-Steueranschluss des zweiten Transistors mit dem Eingangsanschluss der Rampenerzeugungseinheit verbunden ist, die RC-Ladeschaltung über den Widerstand mit dem Eingangsanschluss der Rampenerzeugungseinheit verbunden ist und die Kapazität der RC-Ladeschaltung mit dem Transistor-Steueranschluss des ersten Transistors und des zweiten Transistors verbunden ist. Diese Schaltung hat den Vorteil, dass bei vertretbarem zusätzlichen schaltungstechnischen Aufwand durch den zusätzlichen Transistor, die leistungsmäßige Belastung des Gate-Treibers durch die Rampenerzeugungseinheit verringert werden kann.

Die gegenständliche Erfindung wird nachfolgend unter Bezugnahme auf die Figuren 1 bis 14 näher erläutert, die beispielhaft, schematisch und nicht einschränkend vorteilhafte Ausgestaltungen der Erfindung zeigen. Dabei zeigt
Fig.1 eine erfindungsgemäße Schaltungsanordnung zum Ansteuern eines Halbleiterschaltelements,
Fig.2 eine Ausgestaltung der erfindungsgemäßen Rampenerzeugungseinheit,
Fig.3 eine alternative Ausgestaltung der erfindungsgemäßen Rampenerzeugungseinheit,
Fig.4 eine vereinfachte Darstellung einer erfindungsgemäßen Rampenerzeugungseinheit,
Fig.5 bis 8 Kurven von charakteristischen Strömen und Spannungen der Rampenerzeugungseinheit,
Fig.9 eine weitere Ausgestaltung der erfindungsgemäßen Rampenerzeugungseinheit,
Fig.10 bis 14 Kurven von charakteristischen Strömen und Spannungen dieser Rampenerzeugungseinheit.

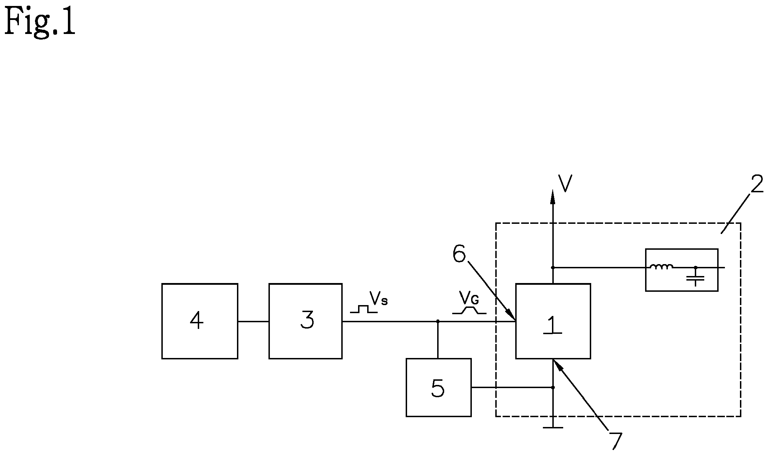

Wie in Fig.1 schematisch dargestellt, wird ein Halbleiterschaltelement 1 beispielsweise als elektronischer Schalter in einer elektrischen Schaltung 2, z.B. ein DC/DC-Konverter, wie in Fig.1 angedeutet, verwendet. Insbesondere kommen solche Halbleiterschaltelemente 1 in Leistungselektronik vor, z.B. in DC/AC-Wandlern, AC/DC-Wandlern oder DC/DC-Wandlern für verschiedenste Anwendungen, beispielsweise in einem Ladegerät im kW-Bereich, einem Schweißgerät oder einem Wechselrichter einer Photovoltaikanlage. Gemein ist solchen leistungselektronischen Schaltungen, dass das Halbleiterschaltelement 1 mit hoher Frequenz geschaltet werden muss. Zum Schalten des Halbleiterschaltelements 1 wird ein Standard Gate-Treiber 3 verwendet, der am Ausgang unter Kontroller einer Steuereinheit 4 eine steilflankige Treiber-Steuerspannung V_{S} einer bestimmten Frequenz zum Ansteuern des Halbleiterschaltelements 1 erzeugt. Die Treiber-Steuerspannung V_{S} wird an den Steueranschluss 6 des Halbleiterschaltelements 1 angelegt, um den Stromfluss über das Halbleiterschaltelement 1 gemäß dem vorgegebenen Schaltverhalten des Halbleiterschaltelements 1 zu kontrollieren. Eingangsseitig wird der Gate-Treiber 3 von einer Steuereinheit 4, z.B. mittels Pulsweitenmodulation (PWM), angesteuert. Solche leistungselektronischen Schaltungen 2 sind hinlänglich bekannt, weshalb hier nicht näher darauf eingegangen wird.

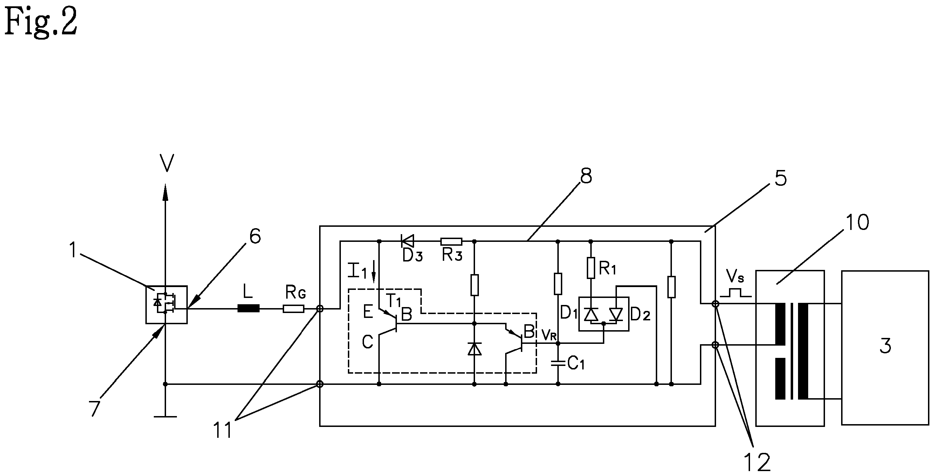

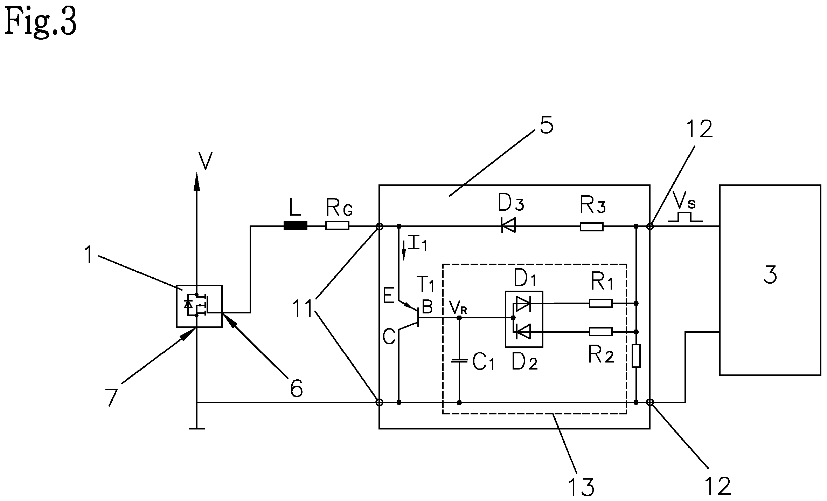

Zwischen Steueranschluss 6 und Ausgangsanschluss 7, z.B. ein Emitteranschluss bei einem IGBT oder ein Source-Anschluss bei einem MOSFET, des Halbleiterschaltelements 1 ist erfindungsgemäß eine Rampenerzeugungseinheit 5 geschaltet, die dafür sorgt, dass der Spannungsanstieg der Rechteckflanke der steilflankigen Treiber-Steuerspannung V_{S} vom Standard Gate-Treiber 3 reduziert wird. Der Ausgangsanschluss 7 liegt normalerweise auf einem Referenzpotential, z.B. einem Nullpotential. Damit soll, im Gegensatz zu den steilen Flanken der Treiber-Steuerspannung V_{S}, eine Transistor-Steuerspannung V_{G} mit definierten steigenden und fallenden Rampen erzeugt werden. Die elektrische Energie zum Betreiben der Rampenerzeugungseinheit 5 kommt dabei direkt vom Gate-Treiber 3, sodass für die Rampenerzeugungseinheit 5 kein zusätzlicher Versorgungsspannungseingang vorzusehen ist. Die Rampenerzeugungseinheit 5 ist eine elektrische Zusatzbeschaltung, die den Gate-Treiber 3 zwar leistungsmäßig belastet (da der Gate-Treiber 3 die elektrische Energie für die Rampenerzeugungseinheit 5 zur Verfügung stellt), jedoch dafür sorgt, dass ein Standard Gate-Treiber 3 verwendet werden kann und nur die mit der steilflankigen Treiber-Steuerspannung V_{S} verbundenen Nachteile eliminiert werden. Mögliche Implementierungen der Rampenerzeugungseinheit 5 werden im Nachfolgenden unter Bezugnahme auf die Fig.2 und 3 beschrieben.

Die Grundidee der Rampenerzeugungseinheit 5 liegt darin, an die Rampenerzeugungseinheit 5 eingangsseitig die vom Gate-Treiber 3 gelieferte Treiber-Steuerspannung V_{S} anzulegen und in der Rampenerzeugungseinheit 5 ausgangsseitig einen Transistor T1 anzuordnen, wobei der Transistor T1 entweder von einer rampenförmig ansteigenden Spannung (bei einer steigenden Flanke der Treiber-Steuerspannung V_{S}) oder einer rampenförmig abfallenden Spannung (bei einer fallenden Flanke der Treiber-Steuerspannung V_{S}) gesteuert wird, sodass über den Transistor T1 ein rampenförmig fallender oder steigender Transistorstrom I₁ fließt. Nachdem der Transistor T1 mit dem Ausgang 11 der Rampenerzeugungseinheit 5 verbunden ist, gibt die Kurvenform des Transistorstromes I₁ die Kurvenform des Ausgangsstromes I_{G} der Rampenerzeugungseinheit 5 vor, und damit auch die Kurvenform der Transistor-Steuerspannung V_{G}, mit der das Halbleiterschaltelement 1 angesteuert wird. Ein rampenförmig steigender oder fallender Transistorstrom I₁ bewirkt dann einen rampenförmig steigenden oder fallenden Ausgangsstrom I_{G} und damit auch eine rampenförmig steigende oder fallende Transistor-Steuerspannung V_{G}.

Im Ausführungsbeispiel nach Fig.2 ist zwischen Gate-Treiber 3 und Rampenerzeugungseinheit 5 ein Signalübertrager 10 mit Potentialtrennung für die Signalübertragung vorgesehen, während im Ausführungsbeispiel nach Fig.3 keine Potentialtrennung vorgesehen ist und der Gate-Treiber 3 direkt an die Rampenerzeugungseinheit 5 angeschlossen ist. In beiden Fällen wird die Rampenerzeugungseinheit 5 ausschließlich vom Gate-Treiber 3 mit elektrischer Energie versorgt. Vor dem Steueranschluss 6 des Halbleiterschaltelements 1 kann in bekannter Weise ein Gate-Widerstand R_{G} und auch eine Induktivität L, beispielsweise ein bekanntes Multilayerferrit zur Filterung von EMV-Störungen, vorgesehen sein. In der nachfolgenden Beschreibung wird auf allfällige Schutzbeschaltung in der Rampenerzeugungseinheit 5, wie z.B. Dioden, Widerstände, nur eingegangen, sofern diese für die erfindungsgemäße Funktion der Rampenerzeugungseinheit 5 von Bedeutung ist. Ansonsten kann vorausgesetzt werden, dass ein Fachmann die Funktion der Schutzbeschaltung erkennt.

Die Rampenerzeugungseinheit 5 weist Eingangsanschlüsse 12 und Ausgangsanschlüsse 11 auf. Einer der Eingangsanschlüsse 12 und Ausgangsanschlüsse 11 sind in bekannter Weise miteinander und mit einem Referenzpotential, z.B. einem Nullpotential, verbunden, weshalb in weitere Folge auch von einem Eingangsanschluss 12 und einem Ausgangsanschluss gesprochen wird. An den Eingangsanschluss 12 wird der Ausgang des Gate-Treibers 3, bzw. der Ausgang des Signalübertragers 10, geschaltet. In der Rampenerzeugungseinheit 5 ist in den gezeigten Ausführungsbeispielen nach den Figuren 2 und 3 ein Eingangsanschluss 12 über eine Leitung 8, in der ein Strombegrenzungswiderstand R3, und gegebenenfalls eine Diode D3, angeordnet sind, mit einem Ausgangsanschluss 11 verbunden. In der Rampenerzeugungseinheit 5 ist parallel zum Ausgangsanschluss 11 der Rampenerzeugungseinheit 5 ein Transistor T1, hier ein pnp-Bipolartransistor, geschaltet. Der Transistor T1 ist damit zwischen Leitung 8 und dem Referenzpotential geschaltet und zweigt damit von der Leitung 8 ab. Anstelle eines pnp-Bipolartransistors kann natürlich auch ein anderer Transistortyp für den Transistor T1 verwendet werden.

In Fig.2 ist der Transistor T1 als bekannte Darlington-Schaltung mittels zwei Transistoren, auch Darlington-Transistor genannt, ausgeführt, was für die Erfindung aber keine weitere Bedeutung hat. Der Darlington-Transistor der Fig.2 wird hier ebenfalls allgemein als Transistor T1 bezeichnet.

Der Transistor T1 ist hier mit dem Transistor-Ausgangsanschluss E, z.B. ein EmitterAnschluss, und dem Transistor-Eingangsanschluss C, z.B. ein Kollektor-Anschluss, (bei einem Darlington-Transistor am ausgangsseitigen Transistor der Darlington-Schaltung) zwischen die Ausgangsanschlüsse 11 der Rampenerzeugungseinheit 5 geschaltet. Der Transistor-Ausgangsanschluss E des Transistors T1 wird dabei mit dem Steueranschluss 6 des Halbleiterschaltelements 1 verbunden, gegebenenfalls über den Gate-Widerstand R_{G} und die Induktivität L.

An den Transistor-Steueranschluss B, z.B. ein Basis-Anschluss, des Transistors T1 (bei einem Darlington-Transistor am eingangsseitigen Transistor der Darlington-Schaltung) wird eine RC-Ladeschaltung 13 bestehend aus einer Kapazität C1 und einem Widerstand R1, bzw. R2, geschaltet. Über die jeweils in Serie zu einem Widerstand R1, R2 geschalteten Dioden D1, D2 werden die Widerstände R1, R2 in Abhängigkeit von der Stromrichtung zugeschaltet. Die Kapazität C1 der RC-Ladeschaltung 13 ist dabei zwischen Transistor-Steueranschluss B und Transistor-Eingangsanschluss C des Transistors T1 (bei einem Darlington Transistor am eingangsseitigen Transistor) geschaltet. Die RC-Ladeschaltung 13 ist außerdem an den Eingang der Rampenerzeugungseinheit 5 geschaltet, indem die Widerstände R1, R2 mit dem Eingangsanschluss 12 verbunden werden..

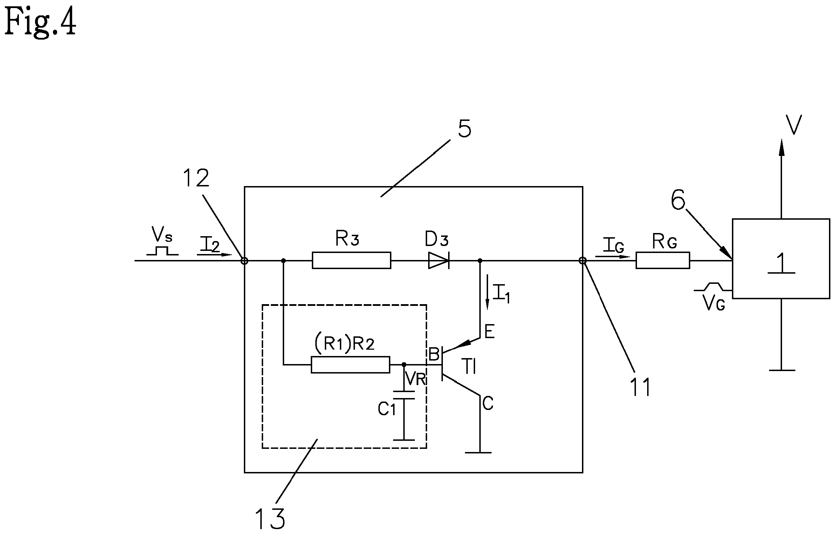

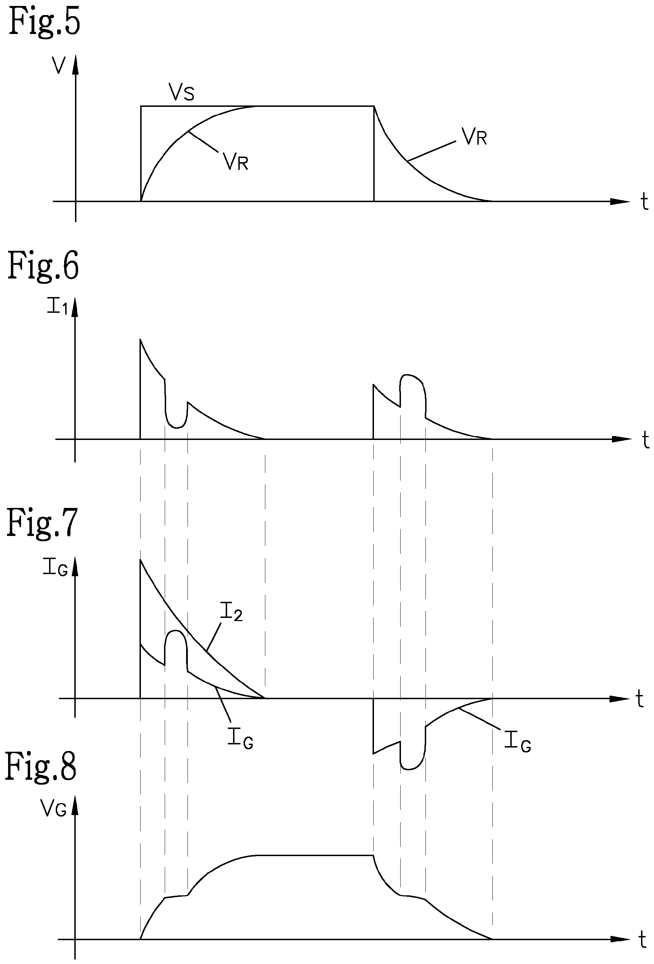

Die Funktion der Rampenerzeugungseinheit 5 wird nun unter Bezugnahme auf die Fig.4, die die Rampenerzeugungseinheit 5 vereinfacht zeigt, und die Figuren 5 bis 8, die charakteristische Signalverläufe zeigen, beschrieben.

An den Eingangsanschluss 12 der Rampenerzeugungseinheit 5 liegt die steilflankige Treiber- Steuerspannung V_{S} des Gate-Treibers 3 an (Fig.5) und es fließt vom Gate-Treiber 3 ein Eingangsstrom I₂ in die Rampenerzeugungseinheit 5. Dadurch liegt die Treiber- Steuerspannung V_{S} auch an die mit dem Eingangsanschluss 12 verbundene RC-Ladeschaltung 13 an, wodurch deren Kondensator C1 aufgeladen wird (Spannung V_{R}), bis die Spannungsniveaus angeglichen sind (Fig.5). Die ansteigende Spannung V_{R} über den Kondensator C1, die an den Transistor-Steueranschluss B des Transistors T1 angelegt ist, steuert den pnp-Typ Transistor T1, was einen rampenförmig abfallenden Strom I₁ über den Transistor T1 bewirkt (Fig.6). Der Transistorstrom I₁ über den Transistor T1 zweigt vom Ausgangsanschluss 11 der Rampenerzeugungseinheit 5 ab, wodurch sich der Ausgangsstrom I_{G} der Rampenerzeugungseinheit 5 aus der Differenz von Eingangsstrom I₂ und dem Transistorstrom I₁ ergibt, also I_{G}=I₂-I₁. Der Strom über die RC-Ladeschaltung 13 wird hier vernachlässigt. Am Halbleiterschaltelement 1 wird damit durch den rampenförmig abfallenden Ausgangsstrom I_{G}, und gegebenenfalls dem Gate-Widerstand R_{G}, an den Steueranschluss 6 eine Transistor-Steuerspannung V_{G} mit flacher steigender, rampenförmiger Flanke angelegt. Die steil ansteigende Flanke der Treiber- Steuerspannung V_{S} wurde damit durch die Rampenerzeugungseinheit 5 rampenförmig abgeflacht. Durch entsprechende Dimensionierung der RC-Ladeschaltung 13 lässt sich diese Wirkung genau einstellen.

Die Rampenerzeugungseinheit 5 versucht damit, eine streng monoton steigende Transistor-Steuerspannung V_{G} zu generieren. Die Stromspitzen bzw. Einbrüche in den Stromverläufen des Transistorstromes I₁ (Fig.6) und des Ausgangsstromes I_{G} (Fig.7) sind eine Folge des bekannten Miller-Effekts im Halbleiterschaltelement 1. Ebenso bewirkt der Miller-Effekt eine kurzfristige Abflachung der steigenden und fallen Flanken der Transistor-Steuerspannung V_{G} (Fig.8).

Analog wird die steil abfallende Flanke der Treiber-Steuerspannung V_{S} vom Gate-Treiber 3 durch die Rampenerzeugungseinheit 5 abgeflacht, wie ebenfalls in den Figuren 5 bis 8 dargestellt. Der abfallende Transistorstrom I₁ wird dabei wiederum vom Ausgangsstrom I_{G} abgezweigt, was zu einer rampenförmigen Abflachung der fallenden Flanke der Transistor-Steuerspannung V_{G} führt.

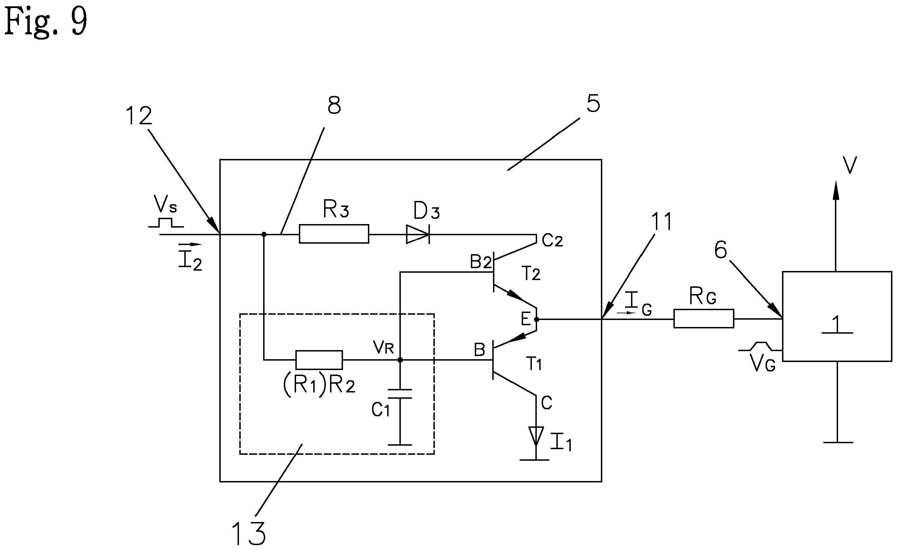

Fig. 9 zeigt eine Abwandlung der erfindungsgemäßen Rampenerzeugungseinheit 5. Hier ist der Transistor T1 nachwievor mit dem Transistor-Ausgangsanschluss E auf den Ausgang 11 der Rampenerzeugungseinheit 5 geschaltet. Der Eingangsanschluss 12 ist hier aber nicht mehr direkt mit der Leitung 8, gegebenenfalls über Widerstand R3 und Diode D3, mit dem Ausgangsanschluss 11 verbunden. Ein zweiter Transistor T2 mit zum Transistor T1 umgekehrten Polarität, hier vom npn-Typ, ist mit dessen Transistor-Ausgangsanschluss E mit dem Transistor-Ausgangsanschluss E des ersten Transistors T1 verbunden und der Transistor-Eingangsanschluss C2 des zweiten Transistors T2 ist mit der Leitung 8 verbunden. Der Transistor-Steueranschluss B2 des zweiten Transistors T2 ist mit dem Transistor-Steueranschluss B des ersten Transistors T1 verbunden, womit auch am Transistor-Steueranschluss B2 des zweiten Transistors T2 die RC-Ladeschaltung 13 mit der Spannung V_{R} anliegt.

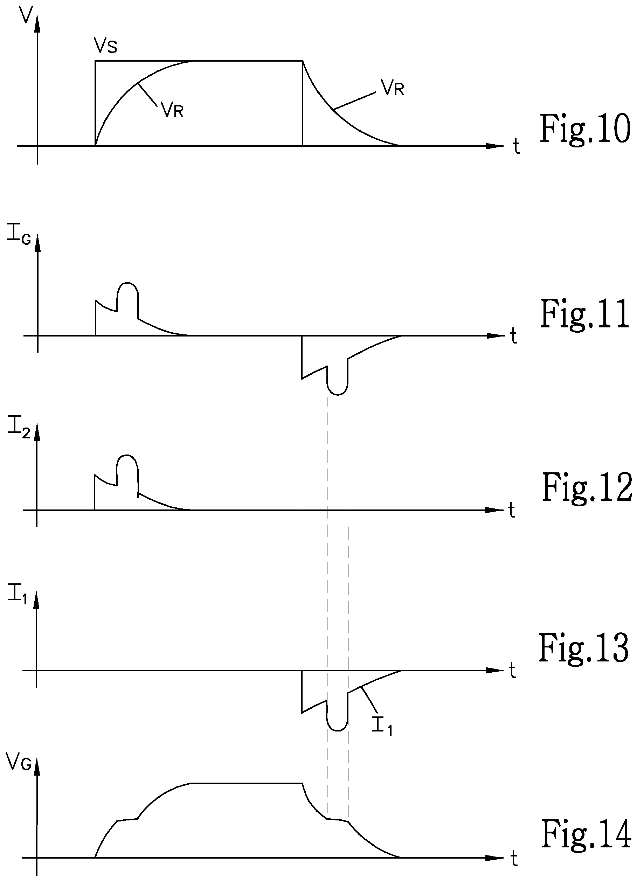

Die Wirkung dieser Schaltung ist identisch zur oben beschriebenen Ausgestaltung der Rampenerzeugungseinheit 5 nach Fig.2 oder 3 und es wird wieder eine rampenförmige Abflachung der Spannungsflanken der Treiber-Steuerspannung V_{S} erzeugt, wie insbesondere aus den Fig. 10 bis 14 hervorgeht.

Der einzige Unterschied besteht darin, dass nun die steigende rampenförmige Flanke der Transistor-Steuerspannung V_{G} vom zweiten Transistor T2 generiert wird und die fallende rampenförmige Flanke der Transistor-Steuerspannung V_{G} vom ersten Transistor T1.

Der Vorteil dieser Schaltung nach Fig.9 liegt darin, dass der Standard Gate-Treiber 3 von dieser Schaltung weniger belastet wird, da für die steigende Flanke der Ausgangsstrom I_{G} gleich dem Eingangsstrom I₂, der auch dem Strom über den zweiten Transistor T2 entspricht, ist. Diesen Vorteil erkauft man sich aber durch einen zusätzlichen Bauteil in Form des zweiten Transistors T2.

## Patentansprüche

1. Schaltungsanordnung zum Ansteuern eines Halbleiterschaltelements (1), wobei ein Gate-Treiber (3) eine steilflankige Treiber-Steuerspannung (Vs) für das Halbleiterschaltelement (1) erzeugt und der Gate-Treiber (3) mit dem Steueranschluss (6) des Halbleiterschaltelements (1) verbunden ist, wobei Steueranschluss (6) des Halbleiterschaltelements (1) über eine Rampenerzeugungseinheit (5) mit dem Ausgangsanschluss (7) des Halbleiterschaltelements (1) verbunden ist, die Rampenerzeugungseinheit (5) zur Erzeugung einer Transistor-Steuerspannung (V_{G}) am Ausgang der Rampenerzeugungseinheit (5) die steil steigenden und fallenden Flanken der Treiber-Steuerspannung (Vs) rampenförmig abflacht und die Energieversorgung der Rampenerzeugungseinheit (5) durch den Gate-Treiber (3) erfolgt, wobei in der Rampenerzeugungseinheit (5) ausgangsseitig ein Transistor (T1, T2) angeordnet ist, der von einer rampenförmig ansteigenden oder abfallenden Spannung (V_{R}) gesteuert ist, wodurch über den Transistor (T1 ,T2) ein rampenförmig fallender oder steigender Transistorstrom (I₁) fließt, und wobei in der Rampenerzeugungseinheit (5) ein erster Transistor (T1) und eine RC-Ladeschaltung (13) mit einem Widerstand (R1, R2) und einem Kondensator (C1) vorgesehen sind, wobei der Transistor-Ausgangsanschluss (E) des ersten Transistors (T1) mit dem Ausgangsanschluss (11) der Rampenerzeugungseinheit (5) verbunden ist, der Widerstand (R1, R2) der RC-Ladeschaltung (13) zwischen dem Eingangsanschluss (12) der Rampenerzeugungseinheit (5) und dem Transistor-Steueranschluss (B) des ersten Transistors (T1) geschalten ist und der Kondensator (C1) der RC-Ladeschaltung (13) mit dem Transistor-Steueranschluss (B) des ersten Transistors (T1) verbunden ist.

2. Schaltungsanordnung nach Anspruch 1, wobei zwischen Gate-Treiber (3) und Rampenerzeugungseinheit (5) ein Signalübertrager (10) geschaltet ist.

3. Schaltungsanordnung nach Anspruch 1 oder 2, wobei in der Rampenerzeugungseinheit (5) ein zweiter Transistor (T2), mit zum ersten Transistor T1 umgekehrten Polarität vorgesehen sind, wobei der Transistor-Ausgangsanschluss (E) des zweiten Transistors (T2) mit dem Transistor-Ausgangsanschluss des ersten Transistors (T1) verbunden ist, sodass der erste Transistor (T1) und der zweite Transistor (T2) in Serie geschaltet sind, und der Kondensator (C1) der RC-Ladeschaltung (13) mit dem Transistor-Steueranschluss (B2) des zweiten Transistors (T2) verbunden ist.

4. Verfahren zum Ansteuern eines Halbleiterschaltelements (1) mit einem Gate-Treiber (3), der mit einem Steueranschluss (6) des Halbleiterschaltelements (1) verbunden wird und der eine steilflankige Treiber-Steuerspannung (V_{S}) erzeugt, wobei vom Gate-Treiber (3) ein Eingangsstrom (I₂) in eine Rampenerzeugungseinheit (5) fließt und der Gate-Treiber (3) die Rampenerzeugungseinheit (5) mit Energie versorgt, wobei in der Rampenerzeugungseinheit (5) vom Eingangsstrom (I₂) ein rampenförmiger Strom (I₁) abgezweigt wird, um einen rampenförmigen Ausgangsstrom (I_{G}) der Rampenerzeugungseinheit (5) zu erzeugen, wobei der rampenförmige Ausgangsstrom (I_{G}) in den Steueranschluss (6) des Halbleiterschaltelements (1) fließt und eine Transistor-Steuerspannung (V_{G}) mit rampenförmig steigenden oder fallenden Flanken bewirkt, wobei in der Rampenerzeugungseinheit (5) eine rampenförmig ansteigende oder abfallenden Spannung (V_{R}) an einen Transistor-Steueranschluss (B) eines ersten Transistors (T1) angelegt wird und die Spannung (V_{R}) den ersten Transistor (T1) steuert und wobei die Transistor-Steuerspannung (V_{G}) mittels einer RC-Ladeschaltung (13) aus der Treiber-Steuerspannung (V_{S}) erzeugt wird.

5. Verfahren nach Anspruch 4, wobei die an einem Kondensator (C1) der RC-Ladeschaltung (13) anliegende Spannung (V_{R}) jeweils an einen Transistor-Steueranschluss (B, B2) von zwei in Serie geschalteten Transistoren (T1, T2) angelegt wird, wobei die Transistoren (T1, T2) über deren Transistor-Ausgangsanschlüsse (E) miteinander und mit dem Steueranschluss (6) des Halbleiterschaltelements (1) verbunden werden.

## Claims

1. A circuit arrangement for controlling a semiconductor switching element (1), wherein a gate driver (3) generates a sharp-edged driver control voltage (V_{S}) for the semiconductor switching element (1) and the gate driver (3) is connected to the control terminal (6) of the semiconductor switching element (1), wherein the control terminal (6) of the semiconductor switching element (1) is connected to the output terminal (7) of the semiconductor switching element (1) via a ramp generation unit (5); the ramp generation unit (5), in order to generate a transistor control voltage (V_{G}) at the output of the ramp generation unit (5), flattens the sharply ascending and descending edges of the driver control voltage (V_{S}) into the form of a ramp; and power is supplied to the ramp generation unit (5) by the gate driver (3) wherein a transistor (T1, T2) is arranged at the output side of the ramp generation unit (5), the transistor (T1, T2) being controlled by a voltage (V_{R}) that ascends or descends in the form of a ramp, whereby a transistor current (I₁) descending or ascending in the form of a ramp flows via the transistor (T1, T2) and wherein a first transistor (T1) and an RC charging circuit (13) comprising a resistor (R1, R2) and a capacitor (C1) are provided in the ramp generation unit (5), wherein the transistor output terminal (E) of the first transistor (T1) is connected to the output terminal (11) of the ramp generation unit (5), the resistor (R1, R2) of the RC charging circuit (13) is connected between the input terminal (12) of the ramp generation unit (5) and the transistor control terminal (B) of the first transistor (T1), and the capacitor (C1) of the RC charging circuit (13) is connected to the transistor control terminal (B) of the first transistor (T1).

2. The circuit arrangement according to claim 1, wherein a signal transformer (10) is connected between the gate driver (3) and the ramp generation unit (5).

3. The circuit arrangement according to claim 1 or 2, wherein a second transistor (T2) having a polarity inverse to that of the first transistor (T1) is provided in the ramp generation unit (5), wherein the transistor output terminal (E) of the second transistor (T2) is connected to the transistor output terminal (E) of the first transistor (T1) so that the first transistor (T1) and the second transistor (T2) are connected in series and the capacitor (C1) of the RC charging circuit (13) is connected to the transistor control terminal (B2) of the second transistor (T2).

4. A method for controlling a semiconductor switching element (1) having a gate driver (3) that is connected to a control terminal (6) of the semiconductor switching element (1) and that generates a sharp-edged driver control voltage (V_{S}), wherein an input current (I₂) flows from the gate driver (3) into a ramp generation unit (5) and the gate driver (3) supplies the ramp generation unit (5) with power, wherein a ramp-shaped current (I₁) is branched off from the input current (I₂) in the ramp generation unit (5), in order to generate a ramp-shaped output current (I_{G}) of the ramp generation unit (5), wherein the ramp-shaped output current (I_{G}) flows into the control terminal (6) of the semiconductor switching element (1) and results in a transistor control voltage (V_{G}) that has edges that ascend or descend in the form of a ramp wherein in the ramp generation unit (5) generates a voltage (V_{R}) that ascends or descends in the form of a ramp, whereby a transistor current (I₁) descending or ascending in the form of a ramp is applied to a transistor control terminal (B) of the first transistor (T1) and the voltage (V_{R}) controls the first transistor (T1) and wherein the transistor control voltage (V_{G}) is generated by the RC charging circuit (13) from the driver control voltage (V_{S}).

5. The method according to claim 4, wherein the voltage (V_{R}) applied at a capacitor (C1) of the RC charging circuit (13) is respectively applied to a transistor control terminal (B, B2) of two transistors (T1, T2) that are connected in series, wherein the transistors (T1, T2) are connected to one another and to the control terminal (6) of the semiconductor switching element (1) via transistor output terminals (E) thereof.

## Revendications

1. Ensemble circuit servant à commander un élément de commutation à semi-conducteur (1), un pilote de grille (3) générant une tension de commande de pilote àflancs brusques (Vs) destinée à l'élément de commutation à semi-conducteur (1) et le pilote de grille (3) étant relié à la borne de commande (6) de l'élément de commutation à semi-conducteur (1), la borne de commande (6) de l'élément de commutation à semi-conducteur (1) étant reliée à la borne de sortie (7) de l'élément de commutation à semi-conducteur (1) par l'intermédiaire d'une unité de génération de rampe (5), l'unité de génération de rampe (5), afin de générer une tension de commande de transistor (V_{G}) à la sortie de l'unité de génération de rampe (5), aplatissant les flancs montants et descendants de façon brusquede la tension de commande de pilote (Vs) en forme de rampe et l'unité de génération de rampe (5) étant alimentée en énergie par le pilote de grille (3), un transistor (T1, T2) étant disposé dans l'unité de génération de rampe (5) côté sortie, lequel est commandé par une tension montante ou descendante en forme de rampe (V_{R}), ce qui permet la circulation d'un courant de transistor descendant ou montant en forme de rampe (I₁) par l'intermédiaire du transistor (T1, T2), et un premier transistor (T1) et un circuit de charge RC (13) comportant une résistance (R1, R2) et un condensateur (C1) étant prévus dans l'unité de génération de rampe (5), la borne de sortie de transistor (E) du premier transistor (T1) étant reliée à la borne de sortie (I₁) de l'unité de génération de rampe (5), la résistance (R1, R2) du circuit de charge RC (13) étant commutée entre la borne d'entrée (12) de l'unité de génération de rampe (5) et la borne de commande de transistor (B) du premier transistor (T1) et le condensateur (C1) du circuit de charge RC (13) étant relié à la borne de commande de transistor (B) du premier transistor (T1).

2. Ensemble circuit selon la revendication 1, un transmetteur de signal (10) étant commuté entre le pilote de grille (3) et l'unité de génération de rampe (5).

3. Ensemble circuit selon la revendication 1 ou 2, un second transistor (T2) doté d'une polarité inversée par rapport au premier transistor (T1) étant prévu dans l'unité de génération de rampe (5), la borne de sortie de transistor (E) du second transistor (T2) étant reliée à la borne de sortie de transistor du premier transistor (T1) de sorte que le premier transistor (T1) et le second transistor (T2) sont commutés en série, et le condensateur (C1) du circuit de charge RC (13) étant relié à la borne de commande de transistor (B2) du second transistor (T2).

4. Procédé de commande d'un élément de commutation à semi-conducteur (1) comportant un pilote de grille (3) qui est relié à une borne de commande (6) de l'élément de commutation à semi-conducteur (1) et qui génère une tension de commande de pilote à flancs brusques (V_{S}), un courant d'entrée (I₂) circulant depuis le pilote de grille (3) dans une unité de génération de rampe (5) et le pilote de grille (3) alimentant l'unité de génération de rampe (5) en énergie, un courant en forme de rampe (I₁) étant dévié à partir du courant d'entrée (I₂) dans l'unité de génération de rampe (5) afin de générer un courant de sortie en forme de rampe (I_{G}) de l'unité de génération de rampe (5), le courant de sortie en forme de rampe (I_{G}) circulant dans la borne de commande (6) de l'élément de commutation à semi-conducteur (1) et créant une tension de commande de transistor (V_{G}) comportant des flancs montants ou descendants en forme de rampe, une tension montante ou descendante en forme de rampe (V_{R}) étant appliquée à une borne de commande de transistor (B) d'un premier transistor (T1) dans l'unité de génération de rampe (5) et la tension (V_{R}) commandant le premier transistor (T1) et la tension de commande du transistor (V_{G}) étant générée à partir de la tension de commande de pilote (V_{S}) au moyen d'un circuit de charge RC (13).

5. Procédé selon la revendication 4, la tension (V_{R}) appliquée à un condensateur (C1) du circuit de charge RC (13) étant appliquée respectivement à une borne de commande de transistor (B, B2) de deux transistors commutés en série (T1, T2), les transistors (T1, T2) étant reliés entre eux et à la borne de commande (6) de l'élément de commutation à semi-conducteur (1) par l'intermédiaire de leurs bornes de sortie de transistor (E).
